# EUROPEAN PATENT APPLICATION

(11) **EP 4 635 934 A1**
(43) Date of publication of application: **22.10.2025**
(21) Application number: 24201638.4
(22) Date of filing: 20.09.2024
(51) Int. Cl.: C04B 37/00, C04B 35/573

(54) **REACTION BONDED SIC-DIAMOND (RBSIC-DIAMOND) COMPOSITE WITH MACHINABLE FEATURES**

(30) Priority: 18.04.2024 US 202418639564
(71) Applicant: II-VI Delaware, Inc., Wilmington, DE 19890 (US)
(72) Inventor: MARSHALL, Andrew, Wilmington, 19890 (US); DENNENY, Kevin, Wilmington, 19890 (US)
(74) Representative: Schmidt, Christian

(57) **Abstract**

Systems and methods are provided for reaction bonded SiC-diamond (RBSiC-Diamond) composite with machinable features. A reaction bonded silicon carbide (SiC) based article may have a main structure formed using a first composite, and machinable areas formed using a second composite added to the main structures, to form a single continuous structure. The first composite may be silicon carbide (SiC) composite combined with at least one other element or compound (e.g., diamond), where the at least one other element or compound is selected to ensure meeting one or more performance criteria. Adding the other element or compound makes the main structure hard to machine or tool. The second composite may include silicon carbide (SiC) composite. The machinable areas may require machining or tooling, and the second composite may be easier to machine or tool than the first composite. The first composite is reaction bond to the second composite through infiltration bonding.

## Description

### TECHNICAL FIELD

Aspects of the present disclosure relate to material solutions, and particularly to performance ceramics and metal matrix composite related solutions. More specifically, certain implementations of the present disclosure relate to methods and systems for implementing and utilizing reaction bonded SiC-diamond (RBSiC-Diamond) composite with machinable features.

### BACKGROUND

Limitations and disadvantages of conventional performance ceramics and metal matrix composites will become apparent to one of skill in the art, through comparison of such systems with some aspects of the present disclosure as set forth in the remainder of the present application with reference to the drawings.

### BRIEF SUMMARY

System and methods are provided for reaction bonded SiC-diamond (RBSiC-Diamond) composite with machinable features, substantially as shown in and/or described in connection with at least one of the figures, as set forth more completely in the claims.

These and other advantages, aspects and novel features of the present disclosure, as well as details of an illustrated embodiment thereof, will be more fully understood from the following description and drawings.

### BRIEF DESCRIPTION OF THE DRAWINGS

Fig. 1 illustrates mold pattern and corresponding silicone mold that may be used in forming reaction bonded SiC-diamond (RBSiC-Diamond) composites with machinable features.
Fig. 2 illustrates example preforms and corresponding infiltrated parts that that may be made when forming reaction bonded SiC-diamond (RBSiC-Diamond) composites with machinable features.
Fig. 3 illustrates example machinable features in reaction bonded SiC-diamond (RBSiC-Diamond) composite based preforms.
Fig. 4 illustrates a flowchart of an example process for forming reaction bonded SiC-diamond (RBSiC-Diamond) composite with machinable features through infiltration bonding and using one continuous structure.

### DETAILED DESCRIPTION

The present disclosure is directed to material solutions, and particularly to performance ceramics and metal matrix composites and processes for forming thereof. In this regard, silicon carbide (SiC) based composites are commonly used in various industries, such as where components or parts are expected to meet certain performance requirements (e.g., strength and/or thermal performance). Such composites may include composites where silicon carbide (SiC) is combined with other materials, compounds, or elements, which may be selected specifically to ensure meeting at least some of the desired performance requirements. For example, in some instances silicon carbide (SiC) may be combined with diamond, thus forming SiC-diamond composites. This may be done, e.g., for use in applications requiring high thermal performance and mechanical stability. In such compositions, diamond may be anywhere from 5% to 75% in the surfaces of the final products (formed components, parts, etc.).

In some instances, the composites may be further processed, such as to further enhance performance. For example, in some instances composites may be reaction-bonded, thus forming reaction bonded ceramics. One such composite is reaction bonded silicon carbide (RBSiC) and diamond (commercially known as Thermadite^{®}). In this regard, Thermadite^{®} composites (and components made therewith) may be used in various industries and/or fields, including, e.g., industrial wear and laser thermal management, etc. Use of Thermadite^{®} composites may be desirable as these composites exhibit such properties as low thermal expansion, high thermal conductivity, high hardness, high wear resistance, high stiffness and chemical inertness.

The manufacturing and/or use of such high performance composites and/or components (e.g., Thermadite^{®} based) may pose certain challenges, however. For example, manufacturing and/or use of such high performance composites and/or components may be challenging when utilizing traditional machining techniques, particularly to manufacture final surface features and/or tolerances. In such instances, more expensive processing techniques and equipment, such as laser based machining techniques and laser based lapping techniques, may need to be added and/or used during the manufacturing process, which may lead to increased costs and/or complexity. Further, the use of such processing techniques and equipment may also require skilled operators able to fully employ these methods, further adding to the cost and/or complexity of the manufacturing processes.

Solutions in accordance with the present disclosure provide enhanced processes for forming such materials, overcoming some of the challenges of conventional solutions. This may be done, e.g., by modifying the forming processes to reduce or even eliminate the need for use of complex machining techniques and equipment, and/or to allow for use of conventional machining methods to be used. In particular, solutions based on the present disclosure may be configured to disrupt or otherwise address the ability for diamond to quickly deteriorate, damage, or even destroy machining tools, to allow such use of conventional machining methods. This may be achieved by, e.g., using and/or configuring forming processes such that manufactured components would be more easily machined in certain areas. For example, when SiC-diamond composites are used, this may be done by forming the components such that they would have less diamond locally in areas that need to be machined or polished.

In various example embodiments, a process may be used in forming silicon carbide (SiC) and diamond composites combined with a reaction-bonded SiC (RBSiC) composite through infiltration bonding and in one continuous structure, to form reaction-bonded SiC-diamond based components with machinable features. In some example embodiments, the process may be configured such that the resultant reaction-bonded SiC-diamond based components may have varying loadings of diamond in a main structure (e.g., up to 75%; preferably 30-75%). In some example embodiments, the process may be configured such that the resultant reaction-bonded SiC-diamond based components may have varying loadings of SiC in machinable areas (e.g., at least 25%; preferably 25-75%). In some example embodiments, the process may be configured such that the resultant reaction-bonded SiC-diamond based components may have varying sizes of diamond in a main structure (e.g., 3-150 µm). In some example embodiments, the process may be configured such that the resultant reaction-bonded SiC-diamond based components may have varying sizes of SiC in machinable areas (e.g., 3-90 µm). In some example embodiments, the process may be configured such that the two composites may be held together prior to bonding. In some example embodiments, the process glue is used to hold the two composites together prior to reaction bonding.

In various example embodiments, an article (e.g., particular component, part, or the like) may be formed comprising of a silicon carbide (SiC) and diamond composite (e.g., Thermadite^{®}) and a reaction-bonded SiC (RBSiC) composite, with the two composites being held together through reaction formed SiC. The SiC (RBSiC) composite may be applied at particular areas in the article. In some embodiments, at least some of the RBSiC areas in the article may be threaded. In some embodiments, at least some of the RBSiC areas in the article may be ground and/or polished. In some embodiments, a bond material may represent the mating surfaces between the SiC-diamond composite and RBSiC composite. In some embodiments, the SiC-diamond and RBSiC materials may be flush with each other (e.g., no bond material used, such as a SiC loaded epoxy).

Reaction bonded SiC and diamond composites with machinable features, as described herein, and the forming processing thereof, may have various attributes and benefits, including, for example: 1) taking advantage of exceptional diamond properties in most of a part (allowing for, e.g., low thermal expansion, high thermal conductivity, high hardness, high wear resistance, high stiffness, and chemical inertness), 2) taking advantage of no diamond loading and low SiC loading where traditional machining or polishing operations are required (as low loaded SiC-Si composites are much kinder to, e.g., traditional ceramic tooling), and 3) being done prior to infiltration (as such allowing for hermetic bonding, and/or eliminating the need to use bonding materials that may be specially made for facilitating the bonding).

Reaction bonded SiC and diamond composites with machinable features, as described herein, may be utilized in various fields and industries and/or may have various applications, such as industrial applications (e.g., impingement surfaces, cutting tools, etc.), semiconductor applications (e.g., dry wafer chucks, wafer chucks with internal cooling, electrostatic chucks, etc.) defense applications (e.g., graded armor materials, etc.), thermal management based applications (e.g., heat sinks for lasers, heat sinks for mirrors, high power electrical heat sinks, etc.), and the like.

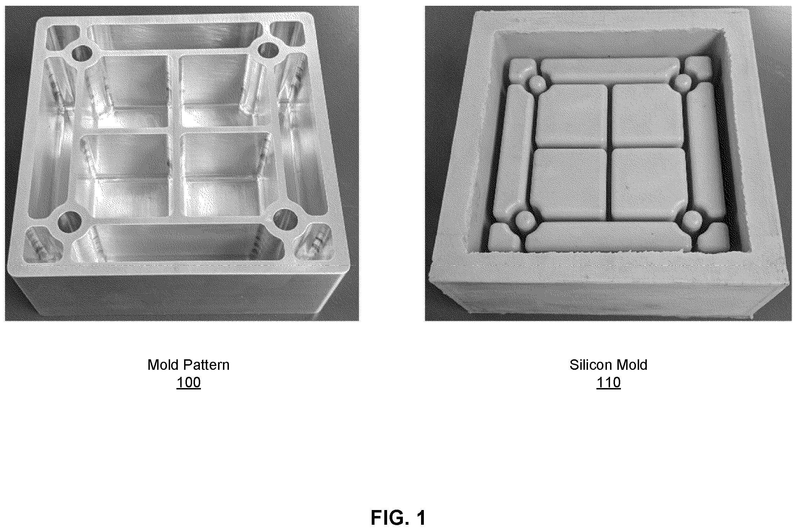

Example embodiments and related features are described in more detail with respect to Figs. 1-4.

Fig. 1 illustrates mold pattern and corresponding silicone mold that may be used in forming reaction bonded SiC-diamond (RBSiC-Diamond) composites with machinable features. Shown in Fig. 1 are mold pattern 100 and silicone mold 110.

The mold pattern 100 may be used in making the silicone mold 110, which in turn is used during the manufacturing process in forming the preform (part). As such, the mold pattern 100 has same shape (more or less) as the part. In this regard, the mold pattern 100 may not be an exact match because, as described herein, certain areas may be filled or otherwise modified (e.g., by adding composite) to make them more easily machinable, and as such the mold pattern 100 may be configured to accommodate making those changes.

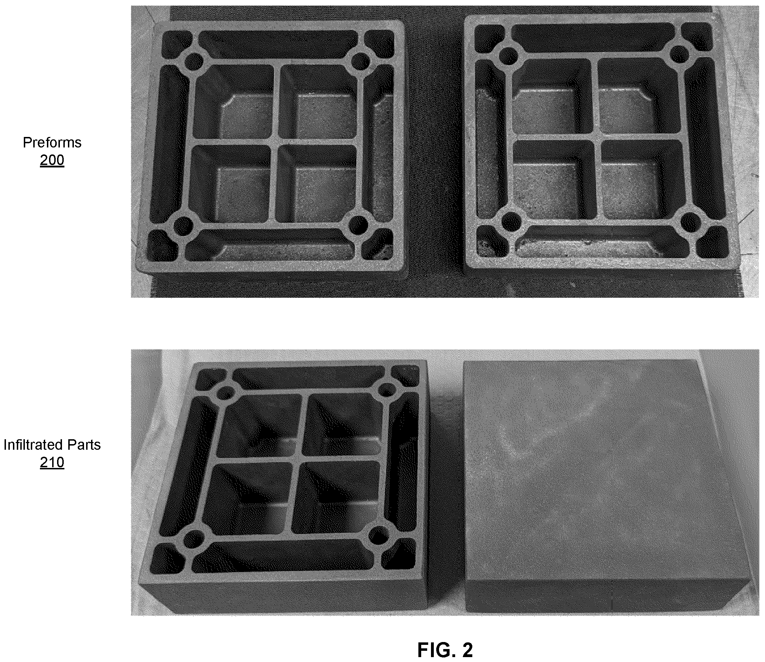

In the example mold pattern 100 illustrated in Fig. 1, e.g., the holes may be larger in the mold pattern 100 than in the part, to allow for adding easily machinable material in them. As such, the mold pattern 100 may allow for making near-net-shape silicone molds. The mold pattern 100 may be made from any suitable material (e.g., stainless steel, or the like), and as such the disclosure is not limited to any particular material. The silicone mold 110 is then made using the mold pattern 100, such as by casting silicone based material into it, to make the silicone mold 110. The silicone mold 110 is then used, as noted, in forming the part (e.g., preforms, as shown in Fig. 2), such as by casting slurry into it, which results in near-net-shape preform.

Fig. 2 illustrates example preforms and corresponding infiltrated parts that may be made when forming reaction bonded SiC-diamond (RBSiC-Diamond) composites with machinable features. Shown in Fig. 2 are preform 200 and infiltrated part 210.

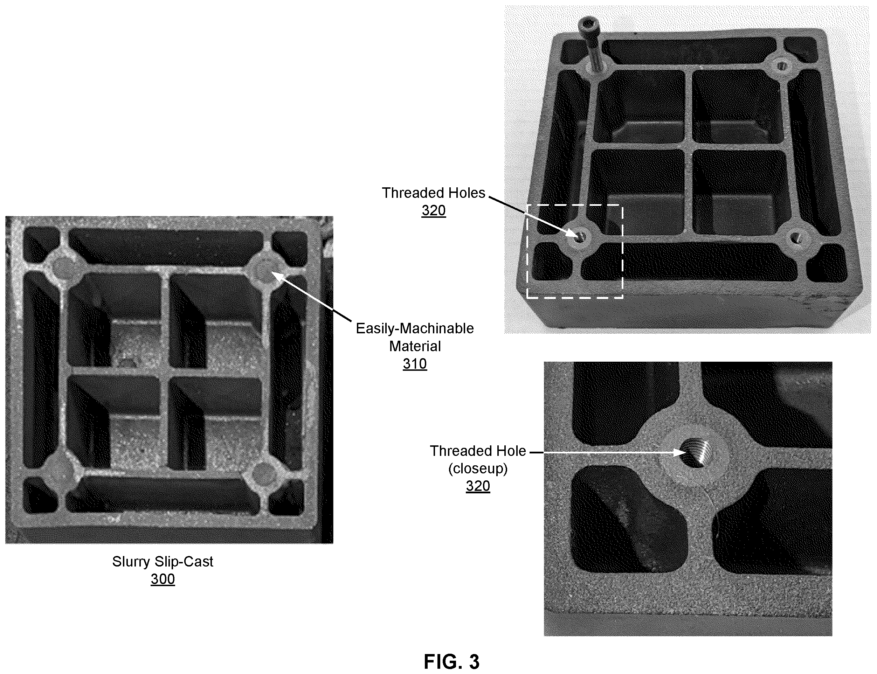

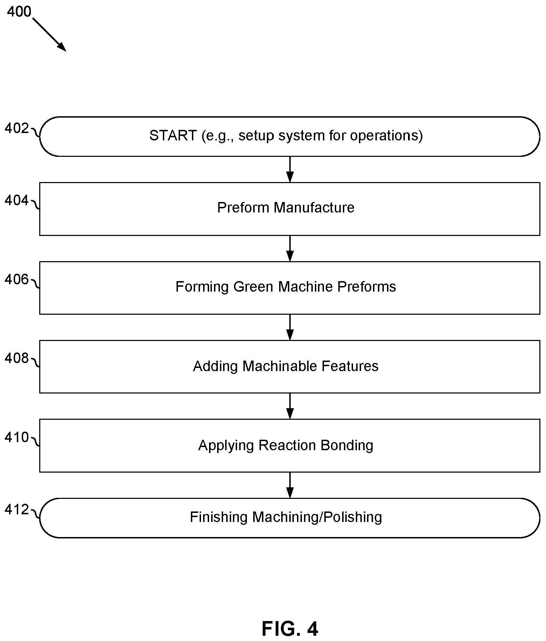

In this regard, as noted, preforms may be made using the silicone molds. This is described in more detail with respect to Fig. 4 (step 404), for example. As illustrated in Fig. 2, e.g., the preform 200 is made using the silicon pattern 110 of Fig. 1, such as by casting slurry into it. The slurry may be a suitable SiC-diamond based slurry. The preform 200 is then treated to create the infiltrated part 210, which is the final, hard-to-machine part. In this regard, the top of the infiltrated part 210 is the green machined top. The machinable areas or features may be added between preform 200 and infiltrated part 210, as illustrated and described in more detail with respect to Fig. 3.

Fig. 3 illustrates example machinable features in reaction bonded SiC-diamond (RBSiC-Diamond) composite based preforms. Shown in Fig. 3 is slurry slip-cast 300.

In this regard, as noted slurry slip-casts may be formed in preforms thus allowing for machinable features of areas after the final thermal step. This is described in more detail with respect to Fig. 4 (steps 402-412). As illustrated in Fig. 3, the slurry slip-cast 300 is formed starting with the preform 200 of Fig. 2. In this regard, as described herein, because hard composites, such as SiC-diamond composites, pose considerable challenges with machining and/or tooling, in embodiments based on the disclosure more easily machinable material (e.g., SiC composites with no diamond or the like) may be placed or otherwise disposed in areas where such machining or tooling would take place.

For example, as illustrated in Fig. 3, easily-machinable material 310 may be added into the slurry slip-cast 300, such as in an area requiring machining or tooling-e.g., to add threadable holes. In this regard, if the areas where the holes are to be added were of standard material-e.g., the same composite in the main structure (that is, SiC-diamond composite)-it would be difficult to machine these areas to form the required holes. However, by applying easily-machinable material 310 in these areas, threaded holes 320 may be formed more easily, particularly using traditional tooling techniques. The easily-machinable material 310 may comprise, e.g., SiC composite with little or without any diamond or any other elements added to the SiC composite of the main structure. The easily-machinable material 310 may be reaction bonded into the composite of the main structure.

Fig. 4 illustrates a flowchart of an example process for forming reaction bonded SiC-diamond (RBSiC-Diamond) composite with machinable features through infiltration bonding and using one continuous structure. Shown in Fig. 4 is flow chart 400, comprising a plurality of example steps (represented as blocks 402-412), which may be performed using suitable apparatuses and/or devices, to form reaction bonded SiC-diamond (RBSiC-Diamond) composite with machinable features, particularly through infiltration bonding and in one continuous structure.

In step 402, the process may be started, such as by setting up (e.g., powering, configuring, etc.) the apparatuses and/or devices required for performing the process.

In step 404, preform manufacture is done. This may comprise a plurality of actions. For example, preform manufacture may comprise casting into near-net-shape silicone mold (e.g., the silicone mold 110) to form the part, then freezing the part, then removing the part from the silicone mold (and putting it on suitable surface, such as graphite), then drying and binder conversion. The drying may be done at suitable conditions, which depend on the material used for the part. For example, in various instances the drying may be done at temperatures slightly below water's boiling temperature. For the binder conversion, the part may be heated up in suitable environment, such as inert atmosphere (e.g., in N2 environment), and converting the binder to carbon.

In step 406, the green machine preforms may be formed. This may comprise a plurality of actions. For example, forming green machined preforms may comprise fly-cutting the casting heads, and machining any other necessary features before the silicon infiltration is performed-that is, before the reaction bonding. In this regard, such machining is an optional action, and is taken only if needed/desired (e.g., to add features, such as pockets, etc.).

In step 408, machinable features are added. In this regard, the machinable features may be added in variety of ways, and the disclosure is not limited to any particular approach, and as such any suitable approach may be used as long as the desirable outcome-the machinable features are added without degrading or otherwise adversely affecting the performance of the finished parts-is achieved. For example, in some implementations machinable features are added by slip casting SiC based slurry into suitable areas in the preform-e.g., holes intended to become threadable attachment points. In other example implementations, machinable features are added by adhering green machined SiC based preforms to pockets for polishable surfaces.

In step 410, reaction bonding is performed. In this regard, reaction bonding is the same as silicon infiltration. This may comprise a plurality of actions. For example, the part (with the added machinable features) is laid up in a vacuum furnace under particular conditions (e.g., duration, temperature, etc.) that may depend on the part. The temperature may be, e.g., above 1410°C. The part may then be brought into contact with molten Si, with the molten Si wicking in and reacting with carbon from binder. The molten Si may also react with the outer surface of diamond, reducing total Si content of part.

In step 412, the process may then end by finish machining/polishing of the part. In this regard, the finish machining/polishing may be done in a variety of ways, and the disclosure is not limited to any particular approach, and as such any suitable approach may be used as long as the desirable outcome is achieved. For example, in some implementations, holes are threaded as appropriate. In other example implementations, surfaces may be ground, lapped, and/or polished where appropriate.

An example method, in accordance with the present disclosure, comprises forming a reaction bonded silicon carbide (SiC) based article with machinable features, where the forming comprises forming a main structure of the reaction bonded silicon carbide (SiC) based article using a first composite, where the first composite comprises silicon carbide (SiC) composite combined with at least one other element or compound, and where the at least one other element or compound is selected to ensure meeting one or more performance criteria; adding a second composite to the main structures at one or more machinable areas to form a single continuous structure, where the second composite comprises silicon carbide (SiC) composite, where the one or more machinable areas require machining or tooling, and where the second composite is easier to machine or tool than the first composite; and treating the single continuous structure such that the first composite reaction bonds to the second composite through infiltration bonding. Thus, at least one other element or compound makes the main structure hard to machine or tool.

In an example embodiment, the at least one other element or compound comprises diamond, and the first composite is SiC-diamond composite.

In an example embodiment, the reaction bonded silicon carbide (SiC) based article has loadings of at least one other element or compound in the main structure of up to 75%.

In an example embodiment, the reaction bonded silicon carbide (SiC) based article has loadings of at least one other element or compound in the main structure of 30% to 75%.

In an example embodiment, the reaction bonded silicon carbide (SiC) based article has loadings of SiC in the one or more machinable areas of at least 25%.

In an example embodiment, the reaction bonded silicon carbide (SiC) based article has loadings of SiC in the one or more machinable areas of 25% to 75%.

In an example embodiment, the reaction bonded silicon carbide (SiC) based article has varying sizes of the at least one other element or compound in the main structure.

In an example embodiment, the reaction bonded silicon carbide (SiC) based article has varying sizes of the at least one other element or compound in the main structure ranging between 3 µm to 150 µm.

In an example embodiment, the reaction bonded silicon carbide (SiC) based article has varying sizes of SiC in the one or more machinable areas.

In an example embodiment, the reaction bonded silicon carbide (SiC) based article has varying sizes of SiC in the one or more machinable areas ranging between 3 µm to 90 µm.

In an example embodiment, the method further comprises holding together the first composite and the second composite prior to the treating of the single continuous structure.

In an example embodiment, the method further comprises holding together the first composite and the second composite prior to the treating of the single continuous structure using glue.

In an example embodiment, the method further comprises machining or tooling the one or more machinable areas after the treating of the single continuous structure.

In an example embodiment, the machining or tooling comprises one or more of threading one or more holes, grinding one or more surfaces, lapping one or more surfaces, and polishing one or more surfaces.

A reaction bonded silicon carbide (SiC) based article comprises a main structure formed using a first composite, where the first composite comprises silicon carbide (SiC) composite combined with at least one other element or compound, and where the at least one other element or compound is selected to ensure meeting one or more performance criteria; and one or more machinable areas formed using a second composite added to the main structures, to form a single continuous structure, where the second composite comprises silicon carbide (SiC) composite, where the one or more machinable areas require machining or tooling, and where the second composite is easier to machine or tool than the first composite; and where the first composite is reaction bonded to the second composite through infiltration bonding. Adding the at least one other element or compound makes the main structure hard to machine or tool.

In an example embodiment, the at least one other element or compound comprises diamond, and wherein the first composite is SiC-diamond composite.

In an example embodiment, the reaction bonded silicon carbide (SiC) based article further comprises a bond material at mating surfaces between the first composite and the second composite.

In an example embodiment, areas corresponding to the first composite and the second composite are flush with each other.

In an example embodiment, at least one of the one or more machinable areas is threaded.

In an example embodiment, at least one of the one or more machinable areas is ground, lapped, and/or polished.

As utilized herein, "and/or" means any one or more of the items in the list joined by "and/or". As an example, "x and/or y" means any element of the three-element set {(x), (y), (x, y)}. In other words, "x and/or y" means "one or both of x and y." As another example, "x, y, and/or z" means any element of the seven-element set {(x), (y), (z), (x, y), (x, z), (y, z), (x, y, z)}. In other words, "x, y and/or z" means "one or more of x, y, and z." As utilized herein, the term "exemplary" means serving as a non-limiting example, instance, or illustration. As utilized herein, the terms "for example" and "e.g." set off lists of one or more non-limiting examples, instances, or illustrations.

As utilized herein the terms "circuits" and "circuitry" refer to physical electronic components (e.g., hardware), and any software and/or firmware ("code") that may configure the hardware, be executed by the hardware, and or otherwise be associated with the hardware. As used herein, for example, a particular processor and memory (e.g., a volatile or non-volatile memory device, a general computer-readable medium, etc.) may comprise a first "circuit" when executing a first one or more lines of code and may comprise a second "circuit" when executing a second one or more lines of code. Additionally, a circuit may comprise analog and/or digital circuitry. Such circuitry may, for example, operate on analog and/or digital signals. It should be understood that a circuit may be in a single device or chip, on a single motherboard, in a single chassis, in a plurality of enclosures at a single geographical location, in a plurality of enclosures distributed over a plurality of geographical locations, etc. Similarly, the term "module" may, for example, refer to a physical electronic components (e.g., hardware) and any software and/or firmware ("code") that may configure the hardware, be executed by the hardware, and or otherwise be associated with the hardware.

As utilized herein, circuitry or module is "operable" to perform a function whenever the circuitry or module comprises the necessary hardware and code (if any is necessary) to perform the function, regardless of whether performance of the function is disabled or not enabled (e.g., by a user-configurable setting, factory trim, etc.).

Other embodiments of the invention may provide a non-transitory computer readable medium and/or storage medium, and/or a non-transitory machine readable medium and/or storage medium, having stored thereon, a machine code and/or a computer program having at least one code section executable by a machine and/or a computer, thereby causing the machine and/or computer to perform the processes as described herein.

Various embodiments in accordance with the present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. A method comprising:
   forming a reaction bonded silicon carbide (SiC) based article with machinable features, wherein the forming comprises:
   forming a main structure of the reaction bonded silicon carbide (SiC) based article using a first composite,
      wherein the first composite comprises silicon carbide (SiC) composite combined with at least one other element or compound, and
      wherein the at least one other element or compound is selected to ensure meeting one or more performance criteria;
   adding a second composite to the main structures at one or more machinable areas to form a single continuous structure,
      wherein the second composite comprises silicon carbide (SiC) composite,
      wherein the one or more machinable areas require machining or tooling, and
      wherein the second composite is easier to machine or tool than the first composite; and
   treating the single continuous structure such that the first composite reaction bonds to the second composite through infiltration bonding.
2. The method according to aspect 1, wherein the at least one other element or compound comprises diamond, and wherein the first composite is SiC-diamond composite.
3. The method according to aspect 1, wherein the reaction bonded silicon carbide (SiC) based article has loadings of the at least one other element or compound in the main structure of up to 75%.
4. The method according to aspect 3, wherein the reaction bonded silicon carbide (SiC) based article has loadings of the at least one other element or compound in the main structure of 30% to 75%.
5. The method according to aspect 1, wherein the reaction bonded silicon carbide (SiC) based article has loadings of SiC in the one or more machinable areas of at least 25%.
6. The method according to aspect 5, wherein the reaction bonded silicon carbide (SiC) based article has loadings of SiC in the one or more machinable areas of 25% to 75%.
7. The method according to aspect 1, wherein the reaction bonded silicon carbide (SiC) based article has varying sizes of the at least one other element or compound in the main structure.
8. The method according to aspect 7, wherein the reaction bonded silicon carbide (SiC) based article has varying sizes of the at least one other element or compound in the main structure ranging between 3 µm to 150 µm.
9. The method according to aspect 1, wherein the reaction bonded silicon carbide (SiC) based article has varying sizes of SiC in the one or more machinable areas.
10. The method according to aspect 9, wherein the reaction bonded silicon carbide (SiC) based article has varying sizes of SiC in the one or more machinable areas ranging between 3 µm to 90 µm.
11. The method according to aspect 1, further comprising holding together the first composite and the second composite prior to the treating of the single continuous structure.
12. The method according to aspect 11, further comprising holding together the first composite and the second composite prior to the treating of the single continuous structure using glue.
13. The method according to aspect 1, further comprising machining or tooling the one or more machinable areas after the treating of the single continuous structure.
14. The method according to aspect 13, wherein the machining or tooling comprises one or more of threading one or more holes, grinding one or more surfaces, lapping one or more surfaces, and polishing one or more surfaces.
15. A reaction bonded silicon carbide (SiC) based article comprising:
   a main structure formed using a first composite,
      wherein the first composite comprises silicon carbide (SiC) composite combined with at least one other element or compound, and
      wherein the at least one other element or compound is selected to ensure meeting one or more performance criteria; and
   one or more machinable areas formed using a second composite added to the main structures, to form a single continuous structure,
      wherein the second composite comprises silicon carbide (SiC) composite,
      wherein the one or more machinable areas require machining or tooling, and
      wherein the second composite is easier to machine or tool than the first composite; and
   wherein the first composite is reaction bond to the second composite through infiltration bonding.
16. The reaction bonded silicon carbide (SiC) based article according to aspect 15, wherein the at least one other element or compound comprises diamond, and wherein the first composite is SiC-diamond composite.
17. The reaction bonded silicon carbide (SiC) based article according to aspect 15, further comprising a bond material at mating surfaces between the first composite and the second composite.
18. The reaction bonded silicon carbide (SiC) based article according to aspect 15, wherein areas corresponding to the first composite and the second composite are flush with each other.
19. The reaction bonded silicon carbide (SiC) based article according to aspect 15, wherein at least one of the one or more machinable areas is threaded.
20. The reaction bonded silicon carbide (SiC) based article according to aspect 15, wherein at least one of the one or more machinable areas is ground, lapped, and/or polished.

Implementations as described herein may relate to the following: Providing systems and methods for reaction bonded SiC-diamond (RBSiC-Diamond) composite with machinable features. A reaction bonded silicon carbide (SiC) based article may have a main structure formed using a first composite, and machinable areas formed using a second composite added to the main structures, to form a single continuous structure. The first composite may be silicon carbide (SiC) composite combined with at least one other element or compound (e.g., diamond), where the at least one other element or compound is selected to ensure meeting one or more performance criteria. Adding the other element or compound makes the main structure hard to machine or tool. The second composite may include silicon carbide (SiC) composite. The machinable areas may require machining or tooling, and the second composite may be easier to machine or tool than the first composite. The first composite is reaction bond to the second composite through infiltration bonding.

The present application claims priority of U.S. Patent Application No. 18/639,564, filed April 18, 2024. The entire disclosure of this application is hereby explicitly incorporated by reference into the present application.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A method comprising:
forming a reaction bonded silicon carbide (SiC) based article with machinable features, wherein the forming comprises:
forming a main structure of the reaction bonded silicon carbide (SiC) based article using a first composite,
wherein the first composite comprises silicon carbide (SiC) composite combined with at least one other element or compound, and
wherein the at least one other element or compound is selected to ensure meeting one or more performance criteria;
adding a second composite to the main structures at one or more machinable areas to form a single continuous structure,
wherein the second composite comprises silicon carbide (SiC) composite,
wherein the one or more machinable areas require machining or tooling, and
wherein the second composite is easier to machine or tool than the first composite; and
treating the single continuous structure such that the first composite reaction bonds to the second composite through infiltration bonding.

2. The method according to claim 1, wherein the at least one other element or compound comprises diamond, and wherein the first composite is SiC-diamond composite.

3. The method according to claim 1 or 2, wherein the reaction bonded silicon carbide (SiC) based article has loadings of the at least one other element or compound in the main structure of up to 75%.

4. The method according to claim 3, wherein the reaction bonded silicon carbide (SiC) based article has loadings of the at least one other element or compound in the main structure of 30% to 75%.

5. The method according to any one of claims 1 to 4, wherein the reaction bonded silicon carbide (SiC) based article has loadings of SiC in the one or more machinable areas of at least 25%, and, optionally, wherein the reaction bonded silicon carbide (SiC) based article has loadings of SiC in the one or more machinable areas of 25% to 75%.

6. The method according to any one of claims 1 to 5, wherein the reaction bonded silicon carbide (SiC) based article has varying sizes of the at least one other element or compound in the main structure, and, optionally, wherein the reaction bonded silicon carbide (SiC) based article has varying sizes of the at least one other element or compound in the main structure ranging between 3 µm to 150 µm.

7. The method according to any one of claims 1 to 6, wherein the reaction bonded silicon carbide (SiC) based article has varying sizes of SiC in the one or more machinable areas, and, optionally, wherein the reaction bonded silicon carbide (SiC) based article has varying sizes of SiC in the one or more machinable areas ranging between 3 µm to 90 µm.

8. The method according to any one of claims 1 to 7, further comprising holding together the first composite and the second composite prior to the treating of the single continuous structure, and, optionally, further comprising holding together the first composite and the second composite prior to the treating of the single continuous structure using glue.

9. The method according to any one of claims 1 to 8, further comprising machining or tooling the one or more machinable areas after the treating of the single continuous structure, and, optionally, wherein the machining or tooling comprises one or more of threading one or more holes, grinding one or more surfaces, lapping one or more surfaces, and polishing one or more surfaces.

10. A reaction bonded silicon carbide (SiC) based article comprising:
a main structure formed using a first composite,
wherein the first composite comprises silicon carbide (SiC) composite combined with at least one other element or compound, and
wherein the at least one other element or compound is selected to ensure meeting one or more performance criteria; and
one or more machinable areas formed using a second composite added to the main structures, to form a single continuous structure,
wherein the second composite comprises silicon carbide (SiC) composite,
wherein the one or more machinable areas require machining or tooling, and
wherein the second composite is easier to machine or tool than the first composite; and
wherein the first composite is reaction bonded to the second composite through infiltration bonding.

11. The reaction bonded silicon carbide (SiC) based article according to claim 10, wherein the at least one other element or compound comprises diamond, and wherein the first composite is SiC-diamond composite.

12. The reaction bonded silicon carbide (SiC) based article according to claim 10 or 11, further comprising a bond material at mating surfaces between the first composite and the second composite.

13. The reaction bonded silicon carbide (SiC) based article according to any one of claims 10 to 12, wherein areas corresponding to the first composite and the second composite are flush with each other.

14. The reaction bonded silicon carbide (SiC) based article according to any one of claims 10 to 13, wherein at least one of the one or more machinable areas is threaded.

15. The reaction bonded silicon carbide (SiC) based article according to any one of claims 10 to 14, wherein at least one of the one or more machinable areas is ground, lapped, and/or polished.
